# EUROPÄISCHE PATENTSCHRIFT

(11) **EP 3 736 581 B1**
(45) Veröffentlichungstag und Bekanntmachung des Hinweises auf die Patenterteilung: **11.10.2023**
(21) Anmeldenummer: 20173428.2
(22) Anmeldetag: 07.05.2020
(51) Int. Cl.: G01R 31/28, G01R 1/04

(54) **TESTVORRICHTUNG ZUM TESTEN ELEKTRISCHER MODULE, VERWENDUNG EINER TESTVORRICHTUNG UND VERFAHREN ZUM TESTEN ELEKTRISCHER MODULE**
TEST DEVICE FOR TESTING ELECTRICAL MODULES, USE OF A TEST DEVICE AND METHOD FOR TESTING ELECTRICAL MODULES
DISPOSITIF D'ESSAI POUR MODULES ÉLECTRIQUES, UTILISATION D'UN DISPOSITIF D'ESSAI ET PROCÉDÉ D'ESSAI DES MODULES ÉLECTRIQUES

(30) Priorität: 10.05.2019 DE 102019003341
(43) Veröffentlichungstag der Anmeldung: 11.11.2020
(73) Patentinhaber: Yamaichi Electronics Deutschland GmbH, 85609 Aschheim-Dornach (DE)
(72) Erfinder: Btahri, Jemei, 4000 Sousse (TN); Quiter, Michael, 57482 Wenden (DE); Serna, Yoann, 6511 Zams (AT)
(74) Vertreter: Müller-Boré & Partner Patentanwälte PartG mbB

(56) Entgegenhaltungen:
- WO-A2-01/69268
- KR-A- 20140 021 913
- US-A1- 2007 079 187
- US-A1- 2014 159 757

## Beschreibung

Die Erfindung betrifft eine Testvorrichtung zum Testen elektrischer Module, die Verwendung dieser Testvorrichtung und ein Verfahren zum Testen elektrischer Module mittels der Testvorrichtung.

Testvorrichtungen zum Testen elektrischer Module, beispielsweise Halbleiterbausteine und oder Printed Circuit Boards (PCB), werden dazu genutzt, um ein zu testendes elektrisches Modul einem Funktionstest und/oder Belastungstest zu unterziehen. Dazu kann vorgesehen sein, dass die Testvorrichtung eine Modulaufnahmeeinheit aufweist, in die das zu testende Modul eingelegt wird. Durch die Modulaufnahmeeinheit wird das zu testende Modul mit der Testvorrichtung elektrisch verbunden. Anschließend kann eine Testprozedur zum Prüfen des zu testenden Moduls mit einer mit der Testvorrichtung gekoppelten Prüfvorrichtung durchgeführt werden. Beispielsweise können in das zu testende Modul Eingabesignale eingegeben werden. Daraufhin durch das zu testende Modul ausgegebene Ausgabesignale können durch die Prüfvorrichtung mit Referenzsignalen verglichen werden, um die Fehlerfreiheit des zu testenden Moduls zu verifizieren. Ferner ist es wünschenswert, das zu testende Modul diverser Testparameter, beispielsweise verschiedene Temperaturen, Luftdrücke, Vibrationen usw. auszusetzen.

Bekannte Testvorrichtungen lassen jedoch lediglich zu, dass nur ein einzelnes zu testendes Modul getestet werden. Es ist jedoch wünschenswert, verschiedene Module gleichzeitig zu testen, so dass die verschiedenen Module während eines Tests den gleichen Testparametern ausgesetzt sind. Des Weiteren ist es erstrebenswert, Umrüstzeiten, d.h. die Dauer der Durchführung eines Modulwechsels, zu reduzieren.

Ferner ist aus der KR 2014 0021913 eine Kameramodul-Testsockel bekannt, welcher umfasst: eine erste Platine, mit der ein erster Sockel mit einer Montageeinheit, an der ein Kameramodul montiert ist, kombiniert ist; eine zweite Platine, mit der ein zweiter Sockel kombiniert ist; ein Drehscharnier, das den ersten und den zweiten Sockel miteinander verbindet, um gedreht zu werden; und ein Verbindungselement, das in dem zweiten Sockel installiert ist und leitend mit einem Kameramodul verbunden ist, das an der Montageeinheit montiert ist, während der erste und der zweite Sockel geschlossen sind.

Die US 2014/159757 A1 offenbart ein System zum Testen von Informationsverarbeitungssystemen. Das System umfasst eine obere Abdeckung mit einer Speicherschaltung und eine untere Plattform zum Aufnehmen einer Test-Leiterplattenbaugruppe (PCBA) mit einem Schlitz. Das System umfasst einen Sensor, der die relative Position der Speicherschaltung und des Schlitzes bestimmt; und eine Host-Steuerung, die über einen Port mit der Test-PCBA und dem Sensor verbunden ist.

Die US 2007/079187 A1 offenbart ein System zum Testen von Speichermodulen mit einem rotierenden Leiterplattenmontageabschnitt mit mehreren Montageflächen, die in verschiedenen Ebenen positioniert und um eine Achse verbunden sind, um eine drehbare Struktur zu bilden, wobei mindestens eine Leiterplatte auf jeder Montagefläche montiert ist, ein Eingang / Ausgang Teil, ein Rotationsmotor, der mit einer Rotationswelle zum Drehen der drehbaren Struktur gekoppelt ist, und eine zentrale Steuerung, die elektrisch mit den Leiterplatten verbunden ist.

Die WO 01/69268 A2 betrifft eine Testbuchse für integrierte Schaltkreise umfassend: einen Sockelkörper zum Herstellen einer elektrischen Verbindung zwischen Leitungen oder Pads eines integrierten Schaltkreises und einer Lastkarte. Eine Deckelanordnung ist durch ein Scharnier schwenkbar mit dem Sockelkörper verbunden und kann zwischen einer geschlossenen Position und einer offenen Position gedreht werden. Die Deckelanordnung kann ohne Werkzeug vom Sockelkörper abgenommen werden.

Es ist daher Aufgabe der vorliegenden Erfindung, eine Testvorrichtung bereitzustellen, mit der verschiedene Module schnell und zuverlässig getestet werden können und welche kurze Umrüstzeiten ermöglicht. Des Weiteren ist es Aufgabe der Erfindung, ein entsprechendes Testverfahren und eine Verwendung der Testvorrichtung vorzuschlagen.

Die Aufgabe wird durch die Gegenstände der unabhängigen Ansprüche gelöst. Bevorzugte Ausführungsformen sind in den abhängigen Ansprüchen definiert.

Ein Aspekt betrifft eine Testvorrichtung zum Testen elektrischer Module, aufweisend:
ein erstes Unterstützungsglied und ein zweites Unterstützungsglied, die zueinander beweglich ausgebildet sind und in einer Betriebsposition der Testvorrichtung zum Testen der elektrischen Module gegenüberliegend angeordnet sind;
eine an dem ersten Unterstützungsglied angeordnete innere Modulaufnahmeeinheit zum elektrischen Kontaktieren eines zu testenden Moduls, wobei die innere Modulaufnahmeeinheit in der Betriebsposition zum Austauschen des zu testenden Moduls unzugänglich ist; und
mindestens eine permanent zugängliche Modulaufnahmeeinheit zum elektrischen Kontaktieren eines weiteren zu testenden Moduls,
wobei die mindestens eine permanent zugängliche Modulaufnahmeeinheit derart an der Testvorrichtung angeordnet ist, dass die mindestens eine permanent zugängliche Modulaufnahmeeinheit in der Betriebsposition zum Austauschen des zu testenden Moduls zugänglich ist, und
wobei die innere Modulaufnahmeeinheit und die mindestens eine permanent zugängliche Modulaufnahmeeinheit dazu ausgebildet sind, die zu testenden Module elektrisch mit der Testvorrichtung zu verbinden.

Die offenbarte Testvorrichtung ermöglicht es, dass mehrere Module, nämlich das zu testende Modul and das weitere zu testende Modul, gleichzeitig getestet werden können. Insbesondere ermöglicht es die Testvorrichtung, das in der inneren Modulaufnahmeeinheit angeordnete Modul und das in der mindestens einen permanent zugänglichen Modulaufnahmeeinheit angeordnete Modul gleichzeitig zu testen, so dass beide Module gleichen Testparametern ausgesetzt werden können.

Ferner kann die Testvorrichtung zum Testen der Module ein Prüfmodul aufweisen oder die Testvorrichtung ist derart ausgebildet, um mit einer Prüfvorrichtung verbunden zu werden. Mittels der Prüfvorrichtung können Eingabesignale für die zu testenden Module, nämlich für das in der inneren Modulaufnahmeeinheit angeordnete Modul und für das in der mindestens einen permanent zugänglichen Modulaufnahmeeinheit angeordnete Modul, bereitgestellt werden. Daraufhin ausgegebene Ausgabesignale der jeweiligen Module können mittels der Prüfvorrichtung mit entsprechenden Referenzsignalen verglichen werden, um zu bestimmen, ob die zu testenden Module fehlerfrei sind.

Des Weiteren ermöglicht die vorgeschlagene Testvorrichtung, dass das in der mindestens einen permanent zugänglichen Modulaufnahmeeinheit angeordnete Modul austauschbar ist obwohl die ersten und zweiten Unterstützungsglieder sich in der Betriebsposition befinden. Somit muss die Position der ersten und zweiten Unterstützungsglieder für einen Austausch des in der mindestens einen permanent zugänglichen Modulaufnahmeeinheit angeordneten Moduls nicht verändert werden, wodurch Umrüstzeiten der Testvorrichtung verkürzt werden.

Vorzugsweise ist die mindestens eine permanent zugängliche Modulaufnahmeeinheit derart an der Testvorrichtung angeordnet ist, dass die mindestens eine permanent zugängliche Modulaufnahmeeinheit auch in einer Testkonfigurationsposition der Testvorrichtung, welche einen Austausch des in der inneren Modulaufnahmeeinheit angeordneten zu testenden Moduls ermöglicht, einen Austausch des Weiteren zu testenden Moduls ermöglicht. Unter dem Begriff "Testkonfigurationsposition" wird eine Anordnung des ersten Unterstützungsglieds und des zweiten Unterstützungsglieds zu einander verstanden, welche es ermöglicht, ein in der inneren Modulaufnahmeeinheit angeordnetes Modul zu tauschen bzw. aufzunehmen.

Ferner ist es vorteilhaft, die mindestens eine permanent zugängliche Modulaufnahmeeinheit für zu testende Module vorzusehen, welche eine höhere Fehlerrate aufweisen und somit gegebenenfalls öfter getauscht werden müssen als Module, welche von der inneren Modulaufnahmeeinheit aufgenommen sind. Folglich ist es möglich, Umrüstzeiten der Testvorrichtung weiter zu reduzieren.

Vorzugsweise ist die Testvorrichtung dazu ausgebildet, dass in der inneren Modulaufnahmeeinheit angeordnete Modul mit dem in der mindestens einen permanent zugänglichen Modulaufnahmeeinheit angeordneten Modul elektrisch zu verbinden. Insbesondere kann vorgesehen sein, Kontaktierungsmittel der inneren Modulaufnahmeeinheit, welche zum elektrischen kontaktieren des zu testenden Moduls ausgebildet sind, direkt mit Kontaktierungsmitteln der mindestens einen permanent zugänglichen Modulaufnahmeeinheit, welche zum elektrischen kontaktieren des Weiteren zu testenden Moduls ausgebildet sind, elektrisch zu verbinden. Unter direkt elektrisch zu verbinden wird verstanden, die Kontaktierungsmittel der inneren Modulaufnahmeeinheit mit den Kontaktierungsmitteln der mindestens einen permanent zugänglichen Modulaufnahmeeinheit über einen elektrischen Leiter zu verbinden. Bevorzugt ist vorgesehen, dass die elektrische Verbindung nicht über etwaige Schaltungen der Testvorrichtung erfolgt.

Auf vorteilhafte Weise können so funktional zusammengehörige Module direkt miteinander verbunden und getestet werden, ohne dass weitere Schaltungen in der Testvorrichtung vorgehalten werden müssen. So kann beispielsweise das zu testende Modul in der inneren Modulaufnahmeeinheit ein Kontrollmodul sein, welches direkt mit einem Kameramodul, beispielsweise einem Charge-Coupled-Device (CCD), als weiteres zu testendes Modul in der mindestens einen permanent zugängliche Modulaufnahmeeinheit elektrisch verbunden wird. Somit kann gewährleistet werden, dass das Kontrollmodul das Kameramodul unmittelbar ansteuert.

Vorzugsweise spannt das erste Unterstützungslied eine Fläche auf, welche in der Betriebsposition im Wesentlichen horizontal verläuft. Ferner spannt das zweite Unterstützungsglied eine Fläche auf, welche in der Betriebsposition der ersten Fläche gegenüberliegend angeordnet ist. Bevorzugt können das erste Unterstützungsglied und das zweite Unterstützungsglied in der Betriebsposition im Wesentlichen parallel zu einander angeordnet sein.

Bevorzugt kann die innere Modulaufnahmeeinheit an einer ersten Seite des ersten Unterstützungsglieds angeordnet sein, welche in der Betriebsposition dem zweiten Unterstützungsglied gegenüberliegt. Ferner kann die innere Modulaufnahmeeinheit auf der ersten Seite des ersten Unterstützungsglieds angeordnet sein, so dass in der Betriebsposition die innere Modulaufnahmeeinheit zwischen dem ersten Unterstützungsglied und dem zweiten Unterstützungsglied angeordnet ist. Alternativ kann die innere Modulaufnahmeeinheit in einer Aussparung des ersten Unterstützungsglieds angeordnet sein, so dass die innere Modulaufnahmeeinheit in der Betriebsposition zumindest abschnittsweise zwischen dem ersten Unterstützungsglied und dem zweiten Unterstützungsglied angeordnet ist. Ferner wird in der Betriebsposition das in der inneren Modulaufnahmeeinheit aufgenommene Modul mittels des zweiten Unterstützungsglieds in der inneren Modulaufnahmeeinheit fixiert bzw. gesichert.

Vorzugsweise sind das erste Unterstützungsglied und das zweite Unterstützungsglied zueinander verschwenkbar ausgebildet und/oder zueinander parallel verschiebbar ausgebildet, um das erste Unterstützungsglied und das zweite Unterstützungsglied in der Betriebsposition anzuordnen.

Vorzugsweise sind in der Testkonfigurationsposition der Testvorrichtung, die zwei zueinander beweglich ausgebildeten Unterstützungslieder dazu ausgebildet, den Zugang zu der inneren Modulaufnahmeeinheit freizugeben. Mit anderen Worten, das erste Unterstützungsglied und das zweite Unterstützungsglied können derart zueinander bewegt werden, dass in der Testkonfigurationsposition ein Zugriff auf das zu testende Modul in der inneren Modulaufnahmeeinheit möglich ist. Unter dem Begriff "Testkonfigurationsposition" wird ferner verstanden, dass ein Einsetzen bzw. Tauschen der Module in der inneren Modulaufnahmeeinheit und in der mindestens einen permanent zugänglichen Modulaufnahmeeinheit möglich ist.

Vorzugsweise ist die mindestens eine permanent zugängliche Modulaufnahmeeinheit als eine erste Modulaufnahmeeinheit ausgebildet ist, die an dem zweiten Unterstützungsglied angeordnet ist. Insbesondere kann die erste Modulaufnahmeeinheit derart an dem zweiten Unterstützungsglied angeordnet sein, dass in der Betriebsposition der Testvorrichtung die erste Modulaufnahmeeinheit für einen Modulaustausch zugänglich ist. Beispielsweise kann die erste Modulaufnahmeeinheit an einer ersten Seite des zweiten Unterstützungsglieds angeordnet sein, welche in der Betriebsposition von dem ersten Unterstützungsglied abgewandt ist.

Vorzugsweise kann die erste Modulaufnahmeeinheit an dem zweiten Unterstützungsglied derart angeordnet sein, dass in der Betriebsposition die Position der inneren Modulaufnahmeeinheit an dem ersten Unterstützungsglied und die Position der ersten Modulaufnahmeeinheit an dem zweiten Unterstützungsglied deckungsgleich sind. Ferner kann die erste Modulaufnahmeeinheit zumindest abschnittsweise in einer Aussparung des zweiten Unterstützungsglieds angeordnet sein, so dass vorteilhafter Weise in der Betriebsposition die erste Modulaufnahmeeinheit das zu testende Modul in der inneren Modulaufnahmeeinheit sichert bzw. fixiert.

Vorzugsweise weist die erste Modulaufnahmeeinheit Kontaktierungsmittel auf, die dazu ausgebildet sind, ein für die erste Modulaufnahmeeinheit vorgesehenes Modul mit einem für die innere Modulaufnahmeeinheit vorgesehenen Modul elektrisch zu kontaktieren. Ferner kann das Kontaktierungsmittel als elektrischer Leiter ausgebildet sein, welcher das für die erste Modulaufnahmeeinheit vorgesehene Modul direkt mit dem für die innere Modulaufnahmeeinheit vorgesehenem Modul elektrisch verbindet. Insbesondere ermöglicht das Kontaktierungsmittel, eine direkte elektrische Kontaktierung beider Module, ohne dass es weiterer Schaltungen bzw. Schaltungselemente der Testvorrichtung bedarf. Somit ist es möglich, funktional zusammengehörige Module miteinander zu testen, ohne dass diese einzeln über die Testvorrichtung angesteuert werden müssen.

Vorzugsweise sind die Kontaktierungsmittel der ersten Modulaufnahmeeinheit als Federkontaktstifte ausgebildet, um das in der inneren Modulaufnahmeeinheit angeordnete Modul mit dem in der ersten Modulaufnahmeeinheit angeordneten Modul elektrisch zu verbinden. Somit kann zwischen den Modulen ein elektrischer Kontakt ohne Löten bereitgestellt werden da der Kontakt über ein entsprechendes an Pressen in der Betriebsposition erfolgt. Vorzugsweise sind die Kontaktierungsmittel beidseitig als Federkontaktstifte ausgebildet, so dass ein erstes Ende eines der Federkontaktstifte das in der inneren Modulaufnahmeeinheit angeordnete Modul elektrisch kontaktiert und ein zweites Ende der Federkontaktstifte das in der ersten Modulaufnahmeeinheit angeordnete Modul elektrisch kontaktiert.

Vorzugsweise weist die erste Modulaufnahmeeinheit ein Sicherungsmittel auf, welches dazu ausgebildet ist, ein für die erste Modulaufnahmeeinheit vorgesehenes Modul in der ersten Modulaufnahmeeinheit zu sichern. Insbesondere kann das Sicherungsmittel mit der ersten Modulaufnahmeeinheit verschwenkbar ausgebildet sein. Ferner wird durch Einnehmen einer Sicherungsposition des Sicherungsmittels gewährleistet, dass das in der ersten Modulaufnahmeeinheit angeordnete Modul gesichert wird und ein elektrischer Kontakt zwischen dem Kontaktierungsmittel und dem Modul hergestellt wird.

Vorzugsweise ist die mindestens eine permanent zugängliche Modulaufnahmeeinheit als eine zweite Modulaufnahmeeinheit ausgebildet ist, die an dem ersten Unterstützungsglied angeordnet ist. Ferner kann die Testvorrichtung dazu ausgebildet sein, dass die zweite Modulaufnahmeeinheit in der Betriebsposition der Testvorrichtung für einen Modulaustausch zugänglich ist. Dazu kann beispielsweise vorgesehen sein, dass das zweite Unterstützungsglied eine Aussparung vorsieht, so dass die zweite Modulaufnahmeeinheit in der Betriebsposition durch das zweite Unterstützungsglied nicht verdeckt wird bzw. in der Betriebsposition der Zugang zu der zweiten Modulaufnahmeeinheit freigegeben ist. Insbesondere kann vorgesehen sein, dass die zweite Modulaufnahmeeinheit an der ersten Seite des ersten Unterstützungsglieds angeordnet ist.

Vorzugsweise sind die innere Modulaufnahmeeinheit, die erste Modulaufnahmeeinheit und die zweite Modulaufnahmeeinheit elektrisch miteinander verbunden, so dass die in den entsprechenden Modulaufnahmeeinheiten angeordneten Module miteinander getestet werden können.

Vorzugsweise ist die Aussparung des zweiten Unterstützungsglieds derart ausgebildet, dass in der Betriebsposition der Zugang zu der zweiten Modulaufnahmeeinheit freigegeben ist. Ferner ist das zweite Unterstützungsglied derart ausgebildet, dass in der Testkonfigurationsposition der Zugang zu der zweiten Modulaufnahmeeinheit freigegeben ist.

Vorzugsweise ist die zweite Modulaufnahmeeinheit dazu ausgebildet, ein für die zweite Modulaufnahmeeinheit vorgesehenes Modul mittels eines wechselbaren Adaptermoduls elektrisch zu kontaktieren. Mit anderen Worten, das Adaptermodul wird zwischen der zweiten Modulaufnahmeeinheit und dem für die zweite Modulaufnahmeeinheit vorgesehenen Modul zwischengeschaltet. Insbesondere kann das Adaptermodul modulaufnahmeeinheitsspezifische Kontaktierungsmittel aufweisen, mit denen das Adaptermodul und die zweite Modulaufnahmeeinheit elektrisch verbunden werden. Ferner kann das Adaptermodul modulspezifische Kontaktierungsmittel aufweisen, mit denen das Adaptermodul und das für die zweite Modulaufnahmeeinheit vorgesehenen Modul elektrisch verbunden werden. Vorzugsweise wird das Adaptermodul verwendet, um Module mit der zweiten Modulaufnahme zu verbinden, welche über eine nicht einfach lösbare elektrische Verbindung verfügen, beispielsweise Steckverbinder oder Steckermodule.

Ein direktes Verbinden solcher Steckermodule mit der zweiten Modulaufnahmeeinheit und wiederholtes Lösen der Steckermodule führt zu einer hohen physischen Beanspruchung der zweiten Modulaufnahmeeinheit und damit zu einer hohen Ausfallrate der zweiten Modulaufnahmeeinheit. Durch die Verwendung eines Adaptermoduls kann die Beanspruchung der zweiten Modulaufnahmeeinheit reduziert werden, da die Beanspruchung durch das Adaptermodul kompensiert wird.

Bei Auftreten eines Defekts des Adaptermoduls, kann dieses einfach ersetzt werden, ohne dass es eines Austauschs der zweiten Modulaufnahmeeinheit bedarf.

Vorzugsweise sind das erste Unterstützungsglied und das zweite Unterstützungsglied mittels eines Bewegungsunterstützungsglieds miteinander verbunden. Das Bewegungsunterstützungsglied ist ferner dazu ausgebildet, die Bewegung des ersten Unterstützungsglieds und des zweiten Unterstützungsglieds zum Einnehmen der Betriebsposition und/oder Testkonfigurationsposition zu unterstützen. Insbesondere kann das Bewegungsunterstützungsglied als Gasdruckfeder ausgebildet sein, welche das Einnehmen der Testkonfigurationsposition unterstützt. Bevorzugt ist das Bewegungsunterstützungsglied dazu ausgebildet, hohen Temperaturen zu widerstehen, damit die Testvorrichtung entsprechenden Testparametern ausgesetzt werden kann. Bevorzugt kann das Bewegungsunterstützungsglied dazu ausgebildet sein, für einen Temperaturbereich von 0°C bis 50°C, von -10°C bis 80°C und besonders bevorzugt von -40°C bis 125°C einsetzbar zu sein. Beispielsweise kann das Bewegungsunterstützungsglied als eine Gasdruckfeder ausgebildet sein. Ferner können auch mehrere Bewegungsunterstützungsglieder vorgesehen sein, so dass die Testvorrichtung beispielsweise mindesten zwei Gasdruckfedern aufweist.

Vorzugsweise sind das erste Unterstützungsglied und das zweite Unterstützungsglied mittels eines Scharniers miteinander verbunden und die Testvorrichtung kann eine Verriegelungseinheit aufweisen, um das erste Unterstützungsglied und das zweite Unterstützungsglied in der Betriebsposition und/oder Testkonfigurationsposition zu verriegeln. Insbesondere kann somit erreicht werden, dass die Testvorrichtung bei einem Vibrationstest sicher in der Betriebsposition verharrt.

Ein weiterer Aspekt der Erfindung betrifft eine Verwendung einer Testvorrichtung gemäß den obigen Ausführungen zum Testen elektrischer Module.

Ein weiterer Aspekt betrifft ein Verfahren zum Testen elektrischer Module mit einer Testvorrichtung gemäß den obigen Ausführungen, aufweisend:
- Aufnehmen eines zu testenden Moduls in der inneren Modulaufnahmeeinheit;
- Herstellen der Betriebsposition der Testvorrichtung;
- Aufnehmen eines weiteren zu testenden Moduls in der mindestens einen permanent zugänglichen Modulaufnahmeeinheit; und
- Durchführen einer Testprozedur zum Testen der aufgenommenen Module.

### Figurenbeschreibung

Nachfolgend wird eine bevorzugte Ausführungsform der Erfindung anhand
der beigefügten Figuren beispielhaft erläutert. Dabei zeigen:
Figur 1: eine perspektivische Ansicht einer Testvorrichtung, welche sich in einer Testkonfigurationsposition befindet;
Figur 2: eine weitere perspektivische Ansicht der Testvorrichtung, welche sich in einer Betriebsposition befindet;
Figur 3: eine Ansicht eines Querschnitts der Testvorrichtung; und
Figur 4: eine perspektivische Ansicht einer Modulaufnahmeeinheit.

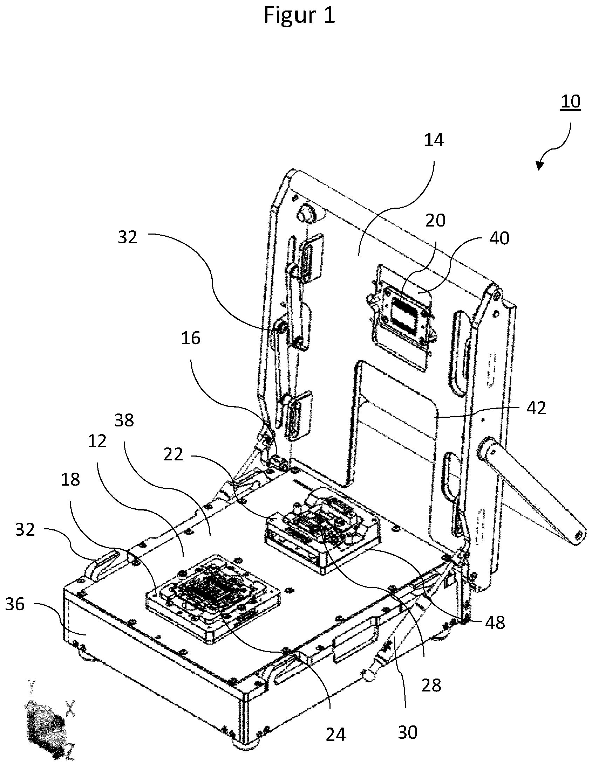

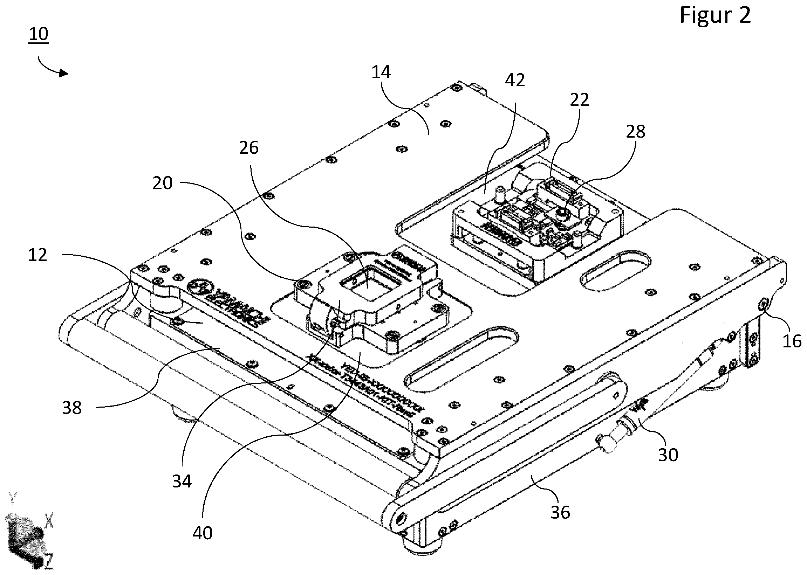

**Figur 1** zeigt eine perspektivische Ansicht einer bevorzugten Ausführungsform einer Testvorrichtung 10 zum Testen elektrischer Module. Die Testvorrichtung 10 weist ein erstes Unterstützungsglied 12 auf, welches mittels eines Verbindungselements 16 mit einem zweiten Unterstützungsglied 14 verbunden ist, so dass das erste Unterstützungsglied 12 und das zweite Unterstützungsglied 14 zueinander beweglich ausgebildet sind. Das Verbindungselement 16 kann beispielsweise als Scharnier ausgebildet sein. Wie aus den Figuren 1 und 2 ersichtlich, sind das erste Unterstützungsglied 12 und das zweite Unterstützungsglied 14 mittels des Verbindungselements 16 zueinander verschwenkbar ausgebildet.

Das erste Unterstützungsglied 12 spannt dabei eine Fläche auf, welche beispielsweise durch eine Leiterplatte 13 definiert wird. Die Leiterplatte 13 kann ferner an einem Gestell 36 angeordnet sein. An einer ersten Seite des ersten Unterstützungsglieds 12 ist eine innere Modulaufnahmeeinheit 18 angeordnet, welche dazu ausgelegt ist, ein zu testendes Modul 24 aufzunehmen. Die innere Modulaufnahmeeinheit 18 weist ferner Kontaktierungsmittel auf, um das aufzunehmende Modul 24 elektrisch zu kontaktieren, so dass mittels der Kontaktierungsmittel eine elektrische Verbindung zwischen der Testvorrichtung 10 und dem Modul 24 hergestellt werden kann. Die Kontaktierungsmittel können bevorzugt als Federkontaktstifte ausgebildet werden.

Figur 1 zeigt beispielhaft eine Testkonfigurationsposition der Testvorrichtung 10, bei der das Modul 24 der inneren Modulaufnahmeeinheit 18 zugänglich ist, um einen Austausch des Moduls 24 vornehmen zu können.

Ferner zeigt Figur 1, dass das zweite Unterstützungsglied 14 eine Fläche aufspannt, an der eine erste Modulaufnahmeeinheit 20 als permanent zugängliche Modulaufnahmeeinheit ausgebildet ist. Des Weiteren zeigt Figur 1 eine zweite Modulaufnahmeeinheit 22, die an der ersten Seite 38 des ersten Unterstützungsglieds 12 angeordnet ist und welche ebenfalls als permanent zugängliche Modulaufnahmeeinheit ausgebildet ist. Unter einer permanent zugänglichen Modulaufnahmeeinheit wird eine Modulaufnahmeeinheit verstanden, welche es unter anderem ermöglicht in einer Betriebsposition der Testvorrichtung 10 einen Zugang zu dem aufgenommenen Modul bereitzustellen, so dass ein Modulaustausch eines in einer permanent zugänglichen Modulaufnahmeeinheit aufgenommenen Moduls möglich ist.

Unter Bezugnahme auf Figur 2 wird die Betriebsposition der Testvorrichtung 10 erläutert. In der Betriebsposition der Testvorrichtung 10 sind das erste Unterstützungsglied 12 und das zweite Unterstützungsglied 14 gegenüberliegend, bevorzugt parallel gegenüberliegend angeordnet. Insbesondere ist die erste Seite 38 des ersten Unterstützungsglieds 12 in der Betriebsposition dem zweiten Unterstützungslied 14 gegenüberliegend angeordnet. Dabei verdeckt in der Betriebsposition das zweite Unterstützungsglied 14 die innere Modulaufnahmeeinheit 18, so dass die innere Modulaufnahmeeinheit 18 in der Betriebsposition zum Austauschen des zu testenden Moduls 24 unzugänglich ist. Ferner ist die erste Modulaufnahmeeinheit 20 an einer Seite des zweiten Unterstützungsglieds 14 angeordnet, welche in der Betriebsposition von dem ersten Unterstützungsglied 12 abgewandt ist. Somit kann ein zu testendes Modul 26, welches von der ersten Modulaufnahmeeinheit 20 aufgenommen ist, auch in der Betriebsposition der Testvorrichtung 10 ausgetauscht werden. Ferner weist das zweite Unterstützungsglied 14 eine erste Aussparung 40 auf, in der die erste Modulaufnahmeeinheit 20 zumindest abschnittsweise angeordnet ist. Bevorzugt ist die erste Modulaufnahmeeinheit 20 an dem zweiten Unterstützungsglied 14 derart positioniert, dass in der Betriebsposition der Testvorrichtung 10 die Position der ersten Modulaufnahmeeinheit 20 mit der Position der inneren Modulaufnahmeeinheit 18 deckungsgleich ist. Dadurch ist es möglich, dass die erste Modulaufnahmeeinheit 20 in der Betriebsposition der Testvorrichtung 10 das Modul 24 in der inneren Modulaufnahmeeinheit 18 sichert bzw. fixiert.

Ferner weist die zweite Modulaufnahmeeinheit 20 ein beweglich ausgebildetes Sicherungsmittel 34 auf, mit der ein in der ersten Modulaufnahmeeinheit 20 aufgenommenes Modul 26 gesichert bzw. fixiert werden kann.

Des Weiteren weist das zweite Unterstützungsglied 14 eine zweite Aussparung 42 auf, welche in der Betriebsposition der Testvorrichtung 10 die zweite Modulaufnahmeeinheit 22 für einen Modulaustausch zugänglich macht.

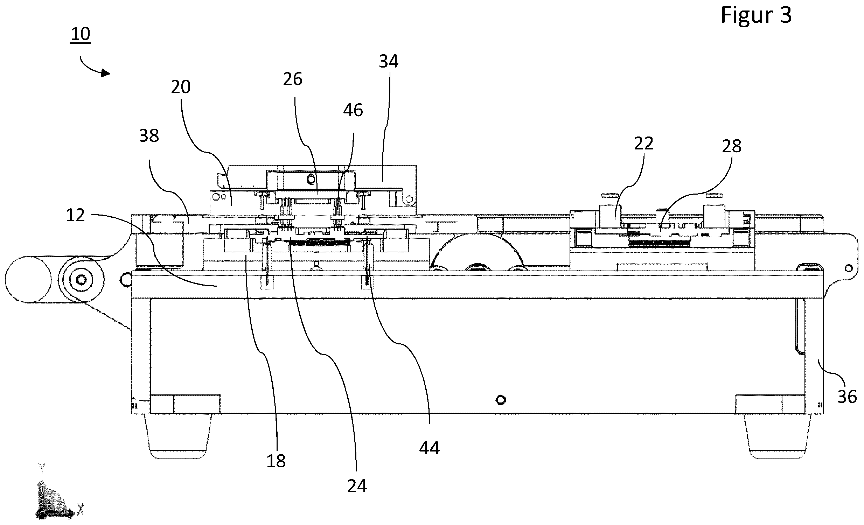

Figur 3 zeigt eine Querschnittsansicht der Testvorrichtung 10, welche sich in der Betriebsposition befindet. Dabei zeigt Figur 3 die auf dem ersten Unterstützungsglied 12 angeordnete innere Modulaufnahmeeinheit 18, welche ein zu testendes Modul 24 aufgenommen hat. Die innere Modulaufnahmeeinheit 18 weist ferner erste Kontaktierungsmittel 44 auf, um das aufgenommene Modul 24 elektrisch mit der Testvorrichtung 10 zu verbinden. Des Weiteren zeigt Fig. 3 die an dem zweiten Unterstützungsglied 14 angeordnete erste Modulaufnahmeeinheit 20, in der ein zu testendes Modul 26 angeordnet ist. Das Modul 26 wird in der ersten Modulaufnahme 20 durch das Sicherungsmittel 34 gesichert bzw. fixiert.

Ferner weist die erste Modulaufnahmeeinheit 20 zweite Kontaktierungsmittel 46 auf, welche dazu ausgebildet sind, das in der inneren Modulaufnahmeeinheit 18 angeordnet Modul 24 mit dem in der ersten Modulaufnahmeeinheit 20 angeordneten Modul 26 direkt elektrisch zu verbinden. Insbesondere kann das zweite Kontaktierungsmittel 46 Federkontaktstifte aufweisen, welche dazu ausgebildet sind, einen elektrischen Kontakt zwischen dem Modul 24 und dem Modul 26 herzustellen. Dadurch ist es möglich, durch Einnehmen der Betriebsposition der Testvorrichtung 10 einen elektrischen Kontakt zwischen dem Modul 24 in der inneren Modulaufnahmeeinheit 18 und dem Modul 26 in der ersten Modulaufnahmeeinheit 18 herzustellen.

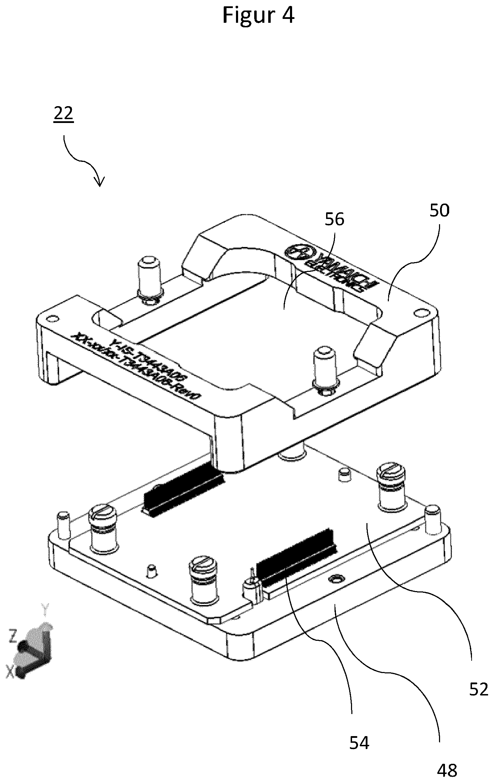

Figur 4 zeigt eine perspektivische Ansicht der zweiten Modulaufnahmeeinheit 28, welche, wie in den Figuren 1 und 2 gezeigt, an dem ersten Unterstützungsglied 12 angeordnet ist. Insbesondere ist die zweite Modulaufnahmeeinheit 22 an der ersten Seite 38 des ersten Unterstützungsglieds 12 angeordnet. Wie in Figur 4 gezeigt weist die zweite Modulaufnahmeeinheit 22 einen ersten Modulaufnahmeeinheitabschnitt 48 und einen zweiten Modulaufnahmeeinheitabschnitt 50 auf, welche miteinander verbindbar sind. Insbesondere ist vorgesehen, dass der erste Modulaufnahmeeinheitabschnitt 48 an dem ersten Unterstützungsglied 12 angeordnet ist. Ferner ist die zweite Modulaufnahmeeinheit 22 dazu ausgelegt, ein Adaptermodul 52 aufzunehmen, welches zwischen dem ersten Modulaufnahmeeinheitabschnitt 48 und dem zweiten Modulaufnahmeeinheitabschnitt 50 anordenbar ist. Insbesondere ist das Adaptermodul 52 zwischen dem ersten Modulaufnahmeeinheitabschnitt 48 und dem zweiten Modulaufnahmeeinheitabschnitt 50 gesichert, so dass das Adaptermodul 52 beim Entfernen des Moduls 28 in der zweiten Modulaufnahmeeinheit 22 verbleibt. Des Weiteren weist der erste Modulaufnahmeeinheitabschnitt 48 dritte Kontaktierungsmittel (nicht gezeigt) auf, um die Testvorrichtung 10 mit einer elektrischen Kontaktierung 54 des Adaptermoduls 52 elektrisch zu verbinden. Die elektrische Kontaktierung 54 des Adaptermoduls 52 ist ferner dazu ausgelegt, dass in der zweiten Modulaufnahmeeinheit 22 aufgenommene Modul 28 elektrisch mit der Testvorrichtung 10 zu verbinden. Bevorzugt kann das Adaptermodul 52 bei einem Defekt durch Lösen des zweiten Modulaufnahmeeinheitabschnitts 50 von dem ersten Modulaufnahmeeinheitabschnitt 48 schnell ausgetauscht werden. Ferner sind die dritten Kontaktierungsmittel lösbar ausgebildet. Mit anderen Worten die dritten Kontaktierungsmittel ermöglichen einen elektrischen Kontakt durch Anpressen des Adaptermoduls 52 an den ersten Modulaufnahmeeinheitabschnitt 48.

Ferner weist der zweite Modulaufnahmeeinheitabschnitt 50 eine Aufnahmeöffnung 56 auf, durch welche das zu testende Modul 28 in der zweiten Modulaufnahmeeinheit 22, insbesondere von dem Adaptermodul 52, aufgenommen wird.

Ferner weist die Testvorrichtung 10 wie in den Figuren 1 und 2 gezeigt ein Bewegungsunterstützungsglied 30 auf, welches das Bewegen des ersten Unterstützungsglieds 12 und des zweiten Unterstützungsglieds 14 in die Betriebsposition und/oder in die Testkonfigurationsposition unterstützt. Insbesondere kann das Bewegungsunterstützungsglied 30 als Gasdruckfeder 30 ausgebildet sein, welche besonders temperaturbeständig ist. Bevorzugt kann die Gasdruckfeder 30 dazu ausgebildet sein, für einen Temperaturbereich von 0°C bis 50°C, von -10°C bis 80°C und besonders bevorzugt von -40°C bis 125°C einsetzbar zu sein. Des Weiteren weist die Testvorrichtung 10 eine Verriegelungseinheit 32 auf, welche das sichere Verriegeln des ersten Unterstützungsglieds 12 und des zweiten Unterstützungsglieds 14 in der Betriebsposition und/oder in der Testkonfigurationsposition ermöglicht.

### Bezugszeichenliste

- 10: Testvorrichtung
- 12: erstes Unterstützungsglied
- 14: zweites Unterstützungsglied
- 16: Verbindungselement
- 18: innere Modulaufnahmeeinheit
- 20: erste Modulaufnahmeeinheit
- 22: zweite Modulaufnahmeeinheit
- 24: Modul (innere Modulaufnahmeeinheit)
- 26: Modul (erste Modulaufnahmeeinheit)
- 28: Modul (zweite Modulaufnahmeeinheit)
- 30: Bewegungsunterstützungsglied
- 32: Verriegelungseinheit
- 34: Sicherungsmittel
- 36: Gestell
- 38: erste Seite des ersten Unterstützungslieds
- 40: erste Aussparung des zweiten Unterstützungsglieds
- 42: zweite Aussparung des zweiten Unterstützungsglieds
- 44: erstes Kontaktierungsmittel
- 46: zweites Kontaktierungsmittel
- 48: erster Modulaufnahmeeinheitabschnitt
- 50: zweiter Modulaufnahmeeinheitabschnitt
- 54: elektrische Kontaktierung
- 56: Aufnahmeöffnung

## Patentansprüche

1. Testvorrichtung (10) zum Testen elektrischer Module (24, 26, 28), aufweisend:
ein erstes Unterstützungsglied (12) und ein zweites Unterstützungsglied (14), die zueinander beweglich ausgebildet sind und in einer Betriebsposition der Testvorrichtung zum Testen der elektrischen Module (24, 26, 28) gegenüberliegend angeordnet sind; und
eine an dem ersten Unterstützungsglied (12) angeordnete innere Modulaufnahmeeinheit (18) zum elektrischen Kontaktieren eines zu testenden Moduls (24), wobei die innere Modulaufnahmeeinheit (18) in der Betriebsposition zum Austauschen des zu testenden Moduls (24) unzugänglich ist; **dadurch gekennzeichnet, dass** die Testvorrichtung weiter aufweist:
mindestens eine permanent zugängliche Modulaufnahmeeinheit (20, 22) zum elektrischen Kontaktieren eines weiteren zu testenden Moduls (26, 28),
wobei die mindestens eine permanent zugängliche Modulaufnahmeeinheit (20, 22) derart an der Testvorrichtung (10) angeordnet ist, dass die permanent zugängliche Modulaufnahmeeinheit in der Betriebsposition zum Austauschen des zu testenden Moduls (26, 28) zugänglich ist, und
wobei die innere Modulaufnahmeeinheit (18) und die zumindest eine permanent zugängliche Modulaufnahmeeinheit (20, 22) dazu ausgebildet sind, die zu testenden Module (24, 26, 28) elektrisch mit der Testvorrichtung zu verbinden.

2. Testvorrichtung (10) nach Anspruch 1, wobei in einer Testkonfigurationsposition der Testvorrichtung, die zwei zueinander beweglich ausgebildeten Unterstützungslieder (12, 14) dazu ausgebildet sind, den Zugang zu der inneren Modulaufnahmeeinheit (18) freizugeben.

3. Testvorrichtung (10) nach Anspruch 1 oder 2, wobei die mindestens eine permanent zugängliche Modulaufnahmeeinheit (20, 22) eine erste Modulaufnahmeeinheit (20) aufweist, die an dem zweiten Unterstützungsglied (14) angeordnet ist.

4. Testvorrichtung (10) nach Anspruch 3, wobei die erste Modulaufnahmeeinheit (20) Kontaktierungsmittel (46) aufweist, die dazu ausgebildet sind, ein für die erste Modulaufnahmeeinheit (20) vorgesehenes Modul (26) mit einem für die innere Modulaufnahmeeinheit (18) vorgesehenen Modul (24) elektrisch zu kontaktieren.

5. Testvorrichtung (10) nach Anspruch 4, wobei die Kontaktierungsmittel (46) als Federkontaktstifte ausgebildet sind, um ein in der inneren Modulaufnahmeeinheit (18) angeordnetes Modul (24) mit einem in der ersten Modulaufnahmeeinheit (20) angeordneten Modul (26) elektrisch zu verbinden.

6. Testvorrichtung (10) nach einem der vorangegangenen Ansprüche 3-5, wobei die erste Modulaufnahmeeinheit (20) ein Sicherungsmittel (34) aufweist, welches dazu ausgebildet ist, ein für die erste Modulaufnahmeeinheit (20) vorgesehenes Modul (26) in der ersten Modulaufnahmeeinheit (20) zu sichern.

7. Testvorrichtung (10) nach einem der vorangegangenen Ansprüche, wobei die mindestens eine permanent zugängliche Modulaufnahmeeinheit eine zweite Modu-Iaufnahmeeinheit (22) aufweist, die an dem ersten Unterstützungsglied (12) angeordnet ist.

8. Testvorrichtung (10) nach Anspruch 7, wobei das zweite Unterstützungsglied (14) eine Aussparung (40) aufweist, die dazu ausgebildet ist, in der Betriebsposition den Zugang zu der zweiten Modulaufnahmeeinheit (22) freizugeben.

9. Testvorrichtung (10) nach Anspruch 7 oder 8, wobei die zweite Modulaufnahmeeinheit (22) dazu ausgebildet ist, ein für die zweite Modulaufnahmeeinheit (22) vorgesehenes Modul (28) mittels eines wechselbaren Adaptermoduls (52) elektrisch zu kontaktieren.

10. Testvorrichtung (10) nach einem der vorangegangenen Ansprüche, wobei das erste Unterstützungsglied (12) und das zweite Unterstützungsglied (14) mittels eines Bewegungsunterstützungsglieds (30) miteinander verbunden sind.

11. Testvorrichtung (10) nach einem der vorangegangenen Ansprüche, wobei das erste Unterstützungsglied (12) und das zweite Unterstützungsglied (14) mittels eines Scharniers (16) miteinander verbunden sind und die Testvorrichtung (10) vorzugsweise eine Verriegelungseinheit (32) aufweist, um das erste Unterstützungsglied (12) und das zweite Unterstützungsglied (14) in der Betriebsposition zu verriegeln.

12. Verwendung einer Testvorrichtung (10) gemäß einem der vorangegangenen Ansprüche zum Testen elektrischer Module (24, 26, 28).

13. Verfahren zum Testen elektrischer Module (24, 26, 28) mit einer Testvorrichtung (10) nach einem der vorangegangenen Ansprüche 1-11, aufweisend:
- Aufnehmen eines zu testenden Moduls (24) in der inneren Modulaufnahmeeinheit (18);
- Herstellen der Betriebsposition der Testvorrichtung (10);
- Aufnehmen eines weiteren zu testenden Moduls (26) in der mindestens einen permanent zugänglichen Modulaufnahmeeinheit (20); und
- Durchführen einer Testprozedur zum Testen der aufgenommenen Module (24, 26).

## Claims

1. Test device (10) for testing electrical modules (24, 26, 28), comprising:
a first support member (12) and a second support member (14) which are configured so as to be movable relative to each other and are oppositely arranged in an operating position of the test device for testing electrical modules (24, 26, 28); and
an internal module receiving unit (18), arranged on the first support member (12), for electrically contacting a module to be tested (24), wherein the internal module receiving unit (18) is inaccessible in the operating position for replacing the module to be tested (24); **characterized in that** the test device further comprises:
at least one permanently accessible module receiving unit (20, 22) for electrically contacting another module to be tested (26, 28),
wherein the at least one permanently accessible module receiving unit (20, 22) is arranged on the test device (10) in such a way that the permanently accessible module receiving unit is accessible in the operating position for replacing the module to be tested (26, 28), and
wherein the internal module receiving unit (18) and the at least one permanently accessible module receiving unit (20, 22) are configured to electrically connect the modules to be tested (24, 26, 28) to the test device.

2. Test device (10) according to claim 1, wherein, in a test configuration position of the test device, the two support members (12, 14) configured so as to be movable relative to each other are configured to release access to the internal module receiving unit (18).

3. Test device (10) according to claim 1 or 2, wherein the at least one permanently accessible module receiving unit (20, 22) comprises a first module receiving unit (20) arranged on the second support member (14).

4. Test device (10) according to claim 3, wherein the first module receiving unit (20) comprises contacting means (46) configured to electrically contact a module (26) provided for the first module receiving unit (20) with a module (24) provided for the internal module receiving unit (18).

5. Test device (10) according to claim 4, wherein the contacting means (46) are configured as spring contact pins for electrically connecting a module (24) arranged in the internal module receiving unit (18) to a module (26) arranged in the first module receiving unit (20).

6. Test device (10) according to any one of the preceding claims 3-5, wherein the first module receiving unit (20) comprises a securing means (34) configured to secure a module (26) provided for the first module receiving unit (20) in the first module receiving unit (20).

7. Test device (10) according to any one of the preceding claims, wherein the at least one permanently accessible module receiving unit comprises a second module receiving unit (22) arranged on the first support member (12).

8. Test device (10) according to claim 7, wherein the second support member (14) comprises a recess (40) configured to release access to the second module receiving unit (22) in the operating position.

9. Test device (10) according to claim 7 or 8, wherein the second module receiving unit (22) is configured to electrically contact a module (28) provided for the second module receiving unit (22) by means of an interchangeable adapter module (52).

10. Test device (10) according to any one of the preceding claims, wherein the first support member (12) and the second support member (14) are connected to each other by means of a movement support member (30).

11. Test device (10) according to any one of the preceding claims, wherein the first support member (12) and the second support member (14) are connected to each other by means of a hinge (16) and the test device (10) preferably comprises a locking unit (32) for locking the first support member (12) and the second support member (14) in the operating position.

12. Use of a test device (10) according to any one of the preceding claims for testing electrical modules (24, 26, 28).

13. Method for testing electrical modules (24, 26, 28) with a test device (10) according to any one of the preceding claims 1-11, comprising:
- receiving a module to be tested (24) in the internal module receiving unit (18);
- establishing the operating position of the test device (10);
- receiving another module to be tested (26) in the at least one permanently accessible module receiving unit (20); and
- executing a test procedure for testing the received modules (24, 26).

## Revendications

1. Dispositif de test (10) pour tester des modules électriques (24, 26, 28), présentant :
un premier élément de support (12) et un deuxième élément de support (14), qui sont configurés sous forme mobile l'un par rapport à l'autre et sont agencés de manière opposée dans une position de fonctionnement du dispositif de test pour tester les modules électriques (24, 26, 28) ; et
une unité de réception de module interne (18) agencée sur le premier élément de support (12) pour établir un contact électrique avec un module à tester (24), l'unité de réception de module interne (18) étant inaccessible dans la position de fonctionnement pour remplacer le module à tester (24) ; **caractérisé en ce que** le dispositif de test présente en outre :
au moins une unité de réception de module accessible en permanence (20, 22) pour établir un contact électrique avec un autre module à tester (26, 28),
l'au moins une unité de réception de module accessible en permanence (20, 22) étant agencée sur le dispositif de test (10) de telle sorte que l'unité de réception de module accessible en permanence est accessible dans la position de fonctionnement pour remplacer le module à tester (26, 28), et
l'unité de réception de module interne (18) et l'au moins une unité de réception de module accessible en permanence (20, 22) étant configurées pour connecter électriquement les modules à tester (24, 26, 28) au dispositif de test.

2. Dispositif de test (10) selon la revendication 1, dans lequel, dans une position de configuration de test du dispositif de test, les deux éléments de support (12, 14) configurés sous forme mobile l'un par rapport à l'autre sont configurés pour libérer l'accès à l'unité de réception de module interne (18).

3. Dispositif de test (10) selon la revendication 1 ou 2, dans lequel l'au moins une unité de réception de module accessible en permanence (20, 22) présente une première unité de réception de module (20), qui est agencée sur le deuxième élément de support (14).

4. Dispositif de test (10) selon la revendication 3, dans lequel la première unité de réception de module (20) présente des moyens de contact (46), qui sont configurés pour mettre en contact électrique un module (26) prévu pour la première unité de réception de module (20) et un module (24) prévu pour l'unité de réception de module interne (18).

5. Dispositif de test (10) selon la revendication 4, dans lequel les moyens de contact (46) sont configurés sous forme de broches de contact à ressort pour connecter électriquement un module (24) agencé dans l'unité de réception de module interne (18) à un module (26) agencé dans la première unité de réception de module (20).

6. Dispositif de test (10) selon l'une quelconque des revendications 3 à 5 précédentes, dans lequel la première unité de réception de module (20) présente un moyen de sécurisation (34), qui est configuré pour sécuriser un module (26) prévu pour la première unité de réception de module (20) dans la première unité de réception de module (20).

7. Dispositif de test (10) selon l'une quelconque des revendications précédentes, dans lequel l'au moins une unité de réception de module accessible en permanence présente une deuxième unité de réception de module (22), qui est agencée sur le premier élément de support (12).

8. Dispositif de test (10) selon la revendication 7, dans lequel le deuxième élément de support (14) présente un évidement (40), qui est configuré pour libérer l'accès à la deuxième unité de réception de module (22) dans la position de fonctionnement.

9. Dispositif de test (10) selon la revendication 7 ou 8, dans lequel la deuxième unité de réception de module (22) est configurée pour mettre en contact électrique un module (28) prévu pour la deuxième unité de réception de module (22) au moyen d'un module adaptateur interchangeable (52).

10. Dispositif de test (10) selon l'une quelconque des revendications précédentes, dans lequel le premier élément de support (12) et le deuxième élément de support (14) sont reliés l'un à l'autre au moyen d'un élément de support de mouvement (30).

11. Dispositif de test (10) selon l'une quelconque des revendications précédentes, dans lequel le premier élément de support (12) et le deuxième élément de support (14) sont reliés l'un à l'autre au moyen d'une charnière (16) et le dispositif de test (10) présente de préférence une unité de verrouillage (32) pour verrouiller le premier élément de support (12) et le deuxième élément de support (14) dans la position de fonctionnement.

12. Utilisation d'un dispositif de test (10) selon l'une quelconque des revendications précédentes pour tester des modules électriques (24, 26, 28).

13. Procédé de test de modules électriques (24, 26, 28) avec un dispositif de test (10) selon l'une quelconque des revendications 1 à 11 précédentes, présentant :
- la réception d'un module à tester (24) dans l'unité de réception de module interne (18) ;
- l'établissement de la position de fonctionnement du dispositif de test (10) ;
- la réception d'un autre module à tester (26) dans l'au moins une unité de réception de module accessible en permanence (20) ; et
- la réalisation de la procédure de test pour tester les modules reçus (24, 26).
